# EUROPEAN PATENT APPLICATION

(11) **EP 4 546 602 A1**
(43) Date of publication of application: **30.04.2025**
(21) Application number: 24189293.4
(22) Date of filing: 17.07.2024
(51) Int. Cl.: H02J 7/00, H02J 7/34

(54) **POWER SUPPLY CIRCUIT, BATTERY MONITORING CIRCUIT, AND ENERGY STORAGE DEVICE**

(30) Priority: 23.10.2023 CN 202322852056 U
(71) Applicant: Sungrow Power Supply Co., Ltd., Hefei, Anhui 230088 (CN)
(72) Inventor: DONG, Wengong, Hefei 230088 (CN); CHEN, Fei, Hefei 230088 (CN); CHEN, Qiangdong, Hefei 230088 (CN); LI, Xuteng, Hefei 230088 (CN); CAO, Ying, Hefei 230088 (CN); JIN, Yongwei, Hefei 230088 (CN)
(74) Representative: Dehns Germany Partnerschaft mbB

(57) **Abstract**

Provided are a power supply circuit, a battery monitoring circuit, and an energy storage device. The power supply circuit is configured to supply power to a management unit of a battery. The battery is connected to an external circuit by a safety protection switch. The power supply circuit includes a voltage conversion circuit, a first line, and a second line. The voltage conversion circuit is connected to two terminals of the safety protection switch through the first line and the second line respectively, and is configured to convert an output voltage of the battery into an operating voltage of the management unit and supply power to the management unit. The second line includes a first switch. The first switch is configured to be switched on when the safety protection switch is switched off, to cause the battery to supply power to the management unit by the voltage conversion circuit via the second line. In this way, damage to the battery or occurrence of safety issue in the battery generated when the management unit cannot monitor the battery can be avoided when a fault or even potential safety hazards occur in the battery.

## Description

### FIELD

The present disclosure relates to the field of battery technologies, and more particularly, to a power supply circuit, a battery monitoring circuit, and an energy storage device.

### BACKGROUND

A cell monitor unit (CMU) is responsible for measuring parameters such as a voltage, current, and temperature of a battery, and then transmitting the parameters to a battery management unit (BMU). The BMU is responsible for evaluating data transmitted by the CMU. If the date is abnormal, protection is performed on the battery.

In the related art, some types of batteries are generally self-powered. For example, a household energy storage battery is self-powered. In a self-powered battery, a voltage output by the battery is output to the CMU for power supply after passing through a micro circuit breaker (MCB), enabling the CMU to operate to monitor the battery. However, after the MCB is disconnected manually or is disconnected due to faults, the battery is disconnected from a power supply circuit of the CMU, and a CMU board cannot operate normally. In this way, when a fault occurs or even potential safety hazards occur in the battery, the CMU cannot monitor the battery, which easily results in damage to the battery or safety issues in the battery.

### SUMMARY

Embodiments of the present disclosure provide a power supply circuit, a battery monitoring circuit, and an energy storage device. The power supply circuit according to the embodiments of the present disclosure is configured to supply power to a management unit of a battery. The battery is connected to an external circuit by a safety protection switch. The power supply circuit includes a voltage conversion circuit, a first line, and a second line. The voltage conversion circuit is connected to two terminals of the safety protection switch by the first line and the second line, respectively. The voltage conversion circuit is configured to convert, when the first switch being switched on, an output voltage of the battery into an operating voltage of the management unit and supply power to the management unit. The second line includes a first switch. The first switch is configured to be switched on when the safety protection switch is switched off, to cause the battery to supply power to the management unit by the voltage conversion circuit via the second line.

In some embodiments, the first switch is a manual switch that is manually switchable off by a user.

In some embodiments, the first switch has a first terminal, a second terminal, and a third terminal. The first terminal is connected to the battery. The second terminal is connected to the first line. The third terminal is connected to the voltage conversion circuit. The first switch is configured to selectively connect the third terminal to the first terminal or to the second terminal, or selectively disconnect the third terminal from the first terminal or from the second terminal.

In some embodiments, the first switch is a single-pole double-throw switch.

In some embodiments, the power supply circuit further includes a third line. The battery is connected to the second line by the third line. The third line includes a second switch. The battery is disconnected from the second line when the second switch is switched off.

In some embodiments, the power supply circuit further includes a fourth line. The fourth line is connected to the first line and the third line. The battery is connected to the voltage conversion circuit by the third line, the fourth line, and the first line when the second switch is switched on.

In some embodiments, the second switch has a fourth terminal, a fifth terminal, and a sixth terminal. The fourth terminal is connected to the battery. The fifth terminal is suspended. The sixth terminal is connected to the second line. The second switch is configured to selectively connect the sixth terminal to the fourth terminal or to the fifth terminal, or selectively disconnect the sixth terminal from the fourth terminal or from the fifth terminal.

In some embodiments, the second switch is a single-pole double-throw switch.

In some embodiments, the voltage conversion circuit is configured to convert, when the safety protection switch is switched on, an output voltage of an energy storage converter of the external circuit into the operating voltage of the management unit through the first line and supply power to the management unit.

In some embodiments, the power supply circuit further includes a fifth line. The fifth line is connected between an energy storage converter and the first line. The fifth line includes a third switch. The third switch is configured to be switched on when the first switch is switched on.

In some embodiments, the power supply circuit further includes an internal power supply. The internal power supply is connected to the management unit to supply power to the management unit.

Embodiments of the present disclosure provide a battery monitoring circuit. The battery monitoring circuit includes the power supply circuit according to any one of the above embodiments and the management unit.

In some embodiments, the management unit is configured to control the first switch to be switched off in response to an abnormal operating state of the battery being detected.

In some embodiments, the first switch has a first terminal, a second terminal, and a third terminal. The first terminal is connected to the battery. The second terminal is connected to the first line. The third terminal is connected to the voltage conversion circuit. The first switch is configured to selectively connect the third terminal to the first terminal or to the second terminal, or selectively disconnect the third terminal from the first terminal or from the second terminal. The management unit is configured to disconnect the third terminal from the first terminal and from the second terminal in response to an abnormal operating state of the battery being detected.

Embodiments of the present disclosure provide an energy storage device. The energy storage device includes a battery and the battery monitoring circuit according to any one of the above embodiments.

In the power supply circuit, the battery monitoring circuit, and the energy storage device according to the embodiments of the present disclosure, the power supply circuit can supply power to the management unit through two power supply loops. In one of the two power supply loop, a voltage of the battery is accessed to the voltage conversion circuit through the safety protection switch and the first line, and then the voltage conversion circuit converts the voltage of the battery into the operating voltage of the management unit to supply power to the management unit. In another one of the two power supply loops, the voltage of the battery is accessed to the voltage conversion circuit through the second line, and then the voltage conversion circuit converts the voltage of the battery into the operating voltage of the management unit to supply power to the management unit. In this way, even if the safety protection switch is switched off due to various conditions, causing the battery not to be connected to the voltage conversion circuit by the first line, the battery can be connected to the voltage conversion circuit by the second line when the first switch is switched on, In this way, the voltage of the battery can be accessed to the voltage conversion circuit through the second line, and then the voltage conversion circuit converts the voltage of the battery into the operating voltage of the management unit to supply power to the management unit, so that the management unit can operate normally. In this way, damage to the battery or occurrence of safety issue in the battery generated when the management unit cannot monitor the battery can be avoided when the safety protection switch is switched off due to various conditions and a fault or even potential safety hazards occur in the battery.

Additional aspects and advantages of the present disclosure will be provided in part in the following description, or will become apparent in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings, in which:
FIG. 1 is a schematic diagram of a power supply circuit according to an embodiment of the present disclosure.
FIG. 2 is a schematic circuit diagram of a power supply circuit according to a first embodiment of the present disclosure.
FIG. 3 is another schematic circuit diagram of a power supply circuit according to a first embodiment of the present disclosure.
FIG. 4 is a schematic circuit diagram of a power supply circuit according to a second embodiment of the present disclosure.
FIG. 5 is a schematic circuit diagram of a power supply circuit according to a third embodiment of the present disclosure.
FIG. 6 is a schematic circuit diagram of a power supply circuit according to a fourth embodiment of the present disclosure.
FIG. 7 is another schematic circuit diagram of a power supply circuit according to a fourth embodiment of the present disclosure.
FIG. 8 is a schematic circuit diagram of a power supply circuit according to a fifth embodiment of the present disclosure.
FIG. 9 is a schematic circuit diagram of a power supply circuit according to a sixth embodiment of the present disclosure.
FIG. 10 is a schematic circuit diagram of a power supply circuit according to a seventh embodiment of the present disclosure.
FIG. 11 is a schematic circuit diagram of a power supply circuit according to an eighth embodiment of the present disclosure.
FIG. 12 is a schematic circuit diagram of a power supply circuit according to a ninth embodiment of the present disclosure.
FIG. 13 is a schematic diagram of a connection of a power supply circuit and an external circuit according to the present disclosure.
FIG. 14 is a schematic circuit diagram of a power supply circuit according to a tenth embodiment of the present disclosure.
FIG. 15 is a schematic circuit diagram of a power supply circuit according to an eleventh embodiment of the present disclosure.
FIG. 16 is a schematic diagram of an energy storage device according to an embodiment of the present disclosure.

### DETAILED DESCRIPTION

Embodiments of the present disclosure will be described in detail below with reference to the described embodiments as illustrated in the accompanying drawings, throughout which same or similar elements, or elements having same or similar functions, are denoted by same or similar reference numerals. The embodiments described below with reference to the drawings are illustrative only, and are intended to explain, rather than limiting, the present disclosure.

In the related art, a cell monitor unit (CMU) is responsible for measuring parameters of a battery, such as a voltage, current, and temperature, and then transmitting the parameters to a battery management unit (BMU). The BMU is responsible for evaluating data transmitted by the CMU. If the data is abnormal, protection is performed on the battery and a request for lowering a current is issued, or a charging or discharging path is cut off, to prevent the battery from exceeding permissible conditions of use. Meanwhile, power and temperature of the battery are also managed.

In the related art, some types of batteries are generally self-powered. For example, a household energy storage battery is self-powered. In a self-powered battery, a voltage output by the battery is output to the CMU for power supply after passing through a micro circuit breaker (MCB), enabling the CMU to operate to monitor the battery. However, after the MCB is disconnected manually or disconnected due to faults, the battery is disconnected from a power supply circuit of the CMU, and a CMU board cannot operate normally. In this way, even if when a fault occurs or even potential safety hazards occur in the battery, the CMU cannot monitor the battery, easily resulting in damage to the battery or the occurrence of safety issues in the battery.

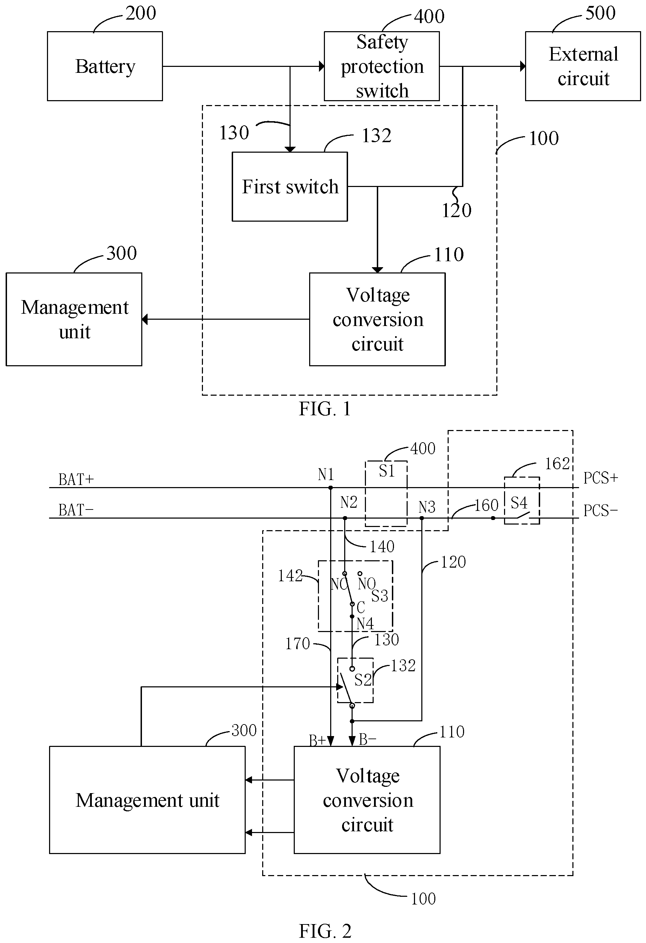

Referring to FIG. 1, an embodiment of the present disclosure provides a power supply circuit 100 for supplying power to a management unit 300 of a battery 200. The battery 200 is connected to an external circuit 500 by a safety protection switch 400. The power supply circuit 100 includes a voltage conversion circuit 110, a first line 120, and a second line 130. The voltage conversion circuit 110 is connected to two terminals of the safety protection switch 400 by the first line 120 and the second line 130, respectively. The voltage conversion circuit 110 is configured to convert, when the safety protection switch 400 is switched on, an output voltage of the battery 200 into an operating voltage of the management unit 300 through the first line 120, and supply power to the management unit 300. The second line 130 includes a first switch 132. The first switch 132 is configured to be switched on when the safety protection switch 400 is switched off, to cause the voltage conversion circuit 110 to supply power to the management unit 300 via the second line 130.

In an exemplary embodiment of the present disclosure, the power supply circuit 100 has two power supply loops. In one of the two power supply loops, the battery 200 is connected to the voltage conversion circuit 110 by the safety protection switch 400 and the first line 120, and the voltage conversion circuit 110 converts an output voltage of the battery 200 into the operating voltage of the management unit 300 to supply power to the management unit 300. In another power supply loop, the battery 200 is connected to the voltage conversion circuit 110 by the second line 130, and the voltage conversion circuit 110 converts the output voltage of the battery 200 into the operating voltage of the management unit 300 to supply power to the management unit 300.

The safety protection switch 400 is configured to control the battery 200 to be connected to or disconnected from the external circuit 500. The battery 200 exchanges electric energy with the external circuit 500 through the safety protection switch 400. When the safety protection switch 400 is switched on, the battery 200 may discharge the external circuit 500, and the external circuit 500 may also charge the battery 200.

The safety protection switch 400 may be a micro circuit breaker (MCB), and the MCB may be manually disconnected or be disconnected due to a fault. For example, in a case where the battery 200 is connected to the external circuit 500, when an input current or an output current of the battery 200 is great, the MCB is disconnected due to overcurrent.

When the safety protection switch 400 is switched off, the battery 200 cannot be connected to the voltage conversion circuit 110 by the first line 120. In this case, when the first switch 132 is switched on, the battery 200 may be connected to the voltage conversion circuit 110 by the second line 130 to supply power to the management unit 300 to allow the management unit 300 to operate normally. The first switch 132 may be a button switch that is manually controllable. When the safety protection switch 400 is switched off, the first switch 132 may be manually controlled to be switched on to allow the management unit 300 to operate normally.

Further, referring to FIG. 2, a BAT+ terminal may be configured to be connected to a positive pole of the battery 200, and a BAT- terminal may be configured to be connected to a negative pole of the battery 200. PCS+ may be configured to be connected to a positive pole of the external circuit 500, and PCS- may be configured to be connected to a negative pole of the external circuit 500. A B+ terminal may be configured to be connected to a positive pole of the voltage conversion circuit 110, and a B- terminal may be configured to be connected to a negative pole of the voltage conversion circuit 110.

The safety protection switch 400 may include a switch S1, and the first switch 132 may include a switch S2. The first line 120 may be a connection line between a third node N3 and the B- terminal, and the second line 130 may be a connection line between a fourth node N4 and the B- terminal. The BAT+ terminal may be connected to the B+ terminal through a first node N1, and the BAT- terminal may be connected to the B- terminal through the first line 120 or the second line 130.

When the switch S1 is switched on, the BAT- terminal may be connected to the B-terminal through the third node N3, i.e., the BAT- terminal may be connected to the B-terminal by the first line 120. Meanwhile, the BAT+ terminal is connected to the B+ terminal through the first node N1. In this case, the output voltage of the battery 200 is accessed to the voltage conversion circuit 110. The voltage conversion circuit 110 may convert the output voltage of the battery 200 into the operating voltage of the management unit 300 and supply power to the management unit 300.

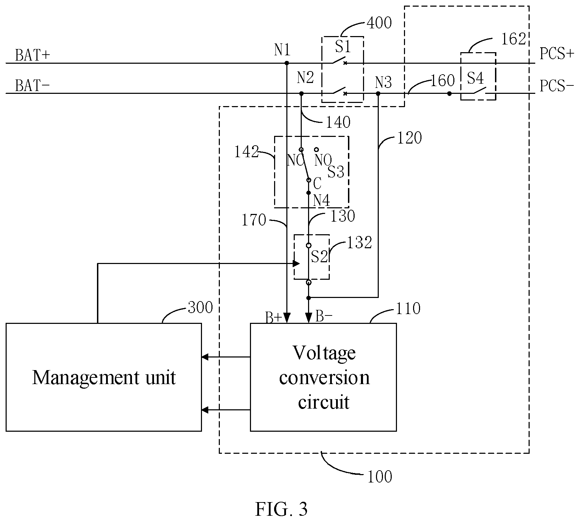

Referring to FIG. 3, when the switch S1 is switched off, the BAT+ terminal and the third node N3 is disconnected from each other, and the BAT- terminal cannot be connected to the B- terminal through the third node N3, i.e., the BAT+ terminal cannot be connected to the B- terminal by the first line 120. In this case, the switch S2 may be controlled to be switched on, so that the BAT- terminal is connected to the B- terminal through the fourth node N4, i.e., the BAT- terminal may be connected to the B- terminal by the second line 130. Meanwhile, the BAT+ terminal is connected to the B+ terminal through the first node N1. In this case, the output voltage of the battery 200 is accessed to the voltage conversion circuit 110. The voltage conversion circuit 110 may convert the output voltage of the battery 200 into the operating voltage of the management unit 300 and supply power to the management unit 300.

In this way, the battery 200 can be connected to the voltage conversion circuit 110 through two power supply loops. When the safety protection switch 400 is switched off, the output voltage of the battery 200 may also be supplied to the voltage conversion circuit 110 through the first switch 132, to allow the voltage conversion circuit 110 to supply power to the management unit 300. The management unit 300 can still operate normally to monitor the battery 200. Therefore, the damage to the battery 200 or the occurrence of the safety issues in the battery 200 due to an inability of the management unit 300 to monitor the battery 200 can be avoided when a fault or even potential safety hazards occur in the battery 200.

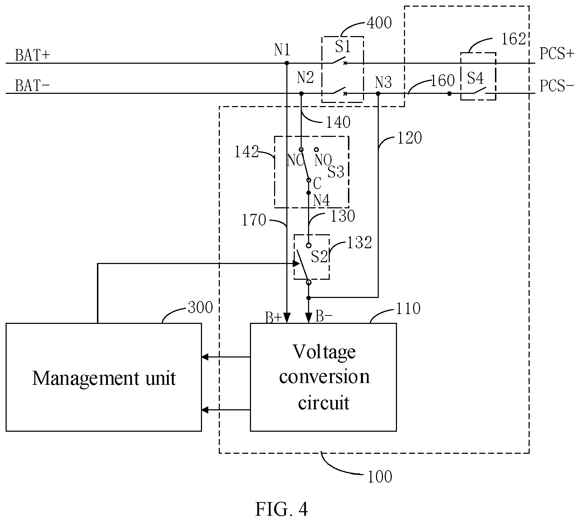

Referring to FIG. 4, in some embodiments, the management unit 300 is configured to detect an operating state of the battery 200. The management unit 300 can control the first switch 132 to be switched off in response to an abnormal operating state of the battery 200 being detected, to disconnect the voltage conversion circuit 110 from the battery 200.

In an exemplary embodiment of the present disclosure, the management unit 300 may be configured to measure a parameter such as a voltage, current, and temperature of the battery 200, and determine the operating state of the battery 200 based on the measurements. When the operating state of the battery 200 is abnormal, protection may be performed on the battery 200, to cause the battery 200 to stop operating. After troubleshooting, the battery 200 is re-controlled to operate.

When the battery 200 has been stopped its operation, the battery 200 cuts off a discharging path simultaneously, and the output voltage of the battery 200 is no longer used for the power supply to the management unit 300 of the battery 200. In this case, the safety protection switch 100 is in an off state, i.e., the switch S1 is in an off state. In this case, if the switch S2 is controlled to be switched off, the voltage conversion circuit 110 cannot be connected to the battery 200 by the second line 130. The voltage conversion circuit 110 is disconnected from the battery 200, to cause the battery 200 to stop supplying power to the management unit 300.

When the battery 200 has an insufficient power, the battery 200 also needs to cut off the discharging path. For example, when the battery 200 is charged by a charging device, the battery 200 needs to cut off the discharging path, and the safety protection switch 100 is in an off state. In this case, if the switch S2 is controlled to be switched off, as described above, the voltage conversion circuit 110 is disconnected from the battery 200, to cause the battery 200 to stop supplying power to the management unit 300.

In this way, when the battery 200 operates abnormally, the battery 200 needs to cut off the discharging path. In this case, the management unit 300 controls the first switch 132 to be switched off, and the battery 200 stops supplying power to the management unit 300.

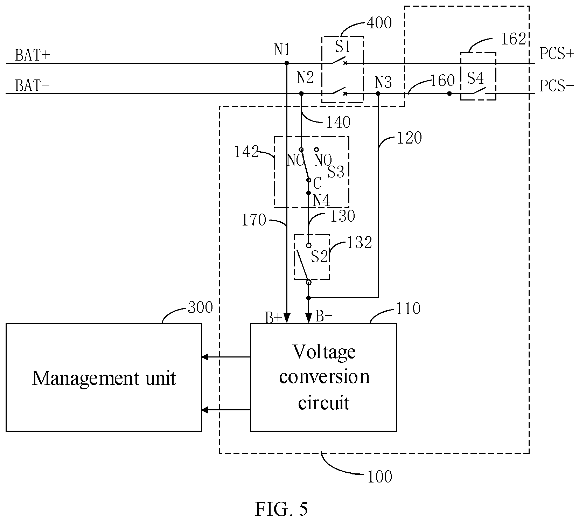

Referring to FIG. 5, in some embodiments, the first switch 132 is a manual switch.

In an exemplary embodiment of the present disclosure, the first switch 132 may include the switch S2 in FIG. 5, and the switch S2 may be a manual switch. A user may manually switch off the first switch 132 as desired. For example, when the abnormal operating state of the battery is detected by the management unit, the management unit may send a corresponding alarm prompt signal to prompt the user. In this case, the safety protection switch 100 is in an off state, i.e., the switch S1 is in an off state.

The user may control the switch S2 to be switched off to cut off the discharging path of the battery 200 for the management unit, and the output voltage of the battery 200 is no longer used for the power supply to the management unit 300 of the battery 200. In this case, the switch S2 is controlled to be switched off, to cause the BAT- terminal and the B-terminal to be disconnected from each other. In this case, the voltage conversion circuit 110 is disconnected from the battery 200, so that the battery 200 stops supplying power to the management unit 300.

When the insufficient power of the battery is detected by the management unit, the management unit may also send a corresponding alarm prompt signal to prompt the user. The user may control the switch S2 to be switched off to cut off the discharging path of the battery 200 for the management unit, and the output voltage of the battery 200 is no longer used for the power supply to the management unit 300 of the battery 200.

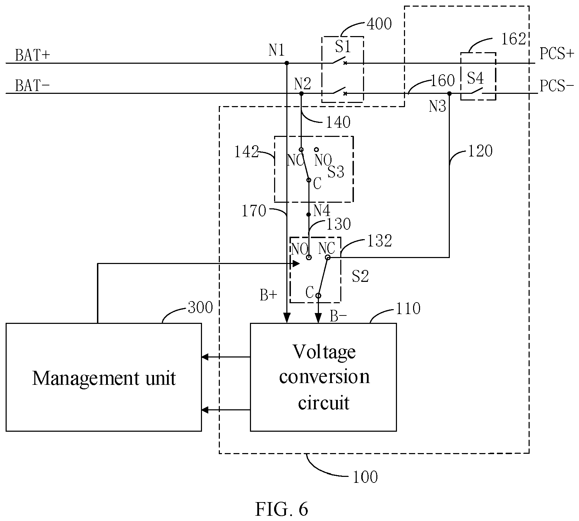

Referring to FIG. 6, in some embodiments, the first switch 132 has a first terminal, a second terminal, and a third terminal. The first terminal is connected to the first line 120. The second terminal is connected to the second line 130. The third terminal is connected to the voltage conversion circuit 110. The first switch 132 is configured to selectively connect the third terminal to the first terminal or to the second terminal, or selectively disconnect the third terminal from the first terminal or from the second terminal.

In an exemplary embodiment of the present disclosure, the first switch 132 may include a switch S2 shown in FIG. 6. A first terminal of the switch S2 is connected to the third node N3, a second terminal of the switch S2 is connected to the fourth node N4, and a third terminal of the switch S2 is connected to the B- terminal.

When the first terminal is connected to the third terminal, the third node N3 may be connected to the B- terminal by the first line 120.

If the switch S1 is switched on, the BAT- terminal may be connected to the third node N3, and connected to the B- terminal through the third node N3 and the switch S3. Meanwhile, the BAT+ terminal is connected to the B+ terminal through the first node N1. In this case, the output voltage of the battery 200 is accessed to the voltage conversion circuit 110. The voltage conversion circuit 110 may convert the output voltage of the battery 200 into the operating voltage of the management unit 300 and supply power to the management unit 300.

If the switch S1 is switched off, the BAT- terminal cannot be connected to the third node N3, and the connection between the BAT- terminal and the B- terminal is disconnected. The voltage conversion circuit 110 is disconnected from the battery 200, so that the battery 200 stops supplying power to the management unit 300.

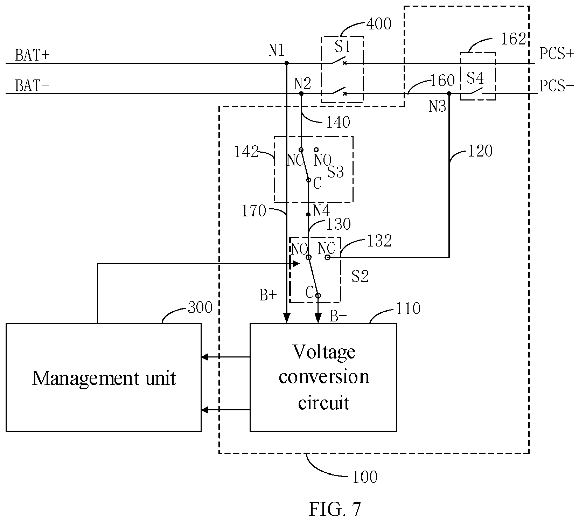

Further, referring to FIG. 7, in a case where the second terminal is connected to the third terminal, the second node N2 may be connected to the B- terminal by the second line 130, and the BAT- terminal may be connected to the B- terminal through the second node N2. Meanwhile, the BAT+ terminal is connected to the B+ terminal through the first node N1. In this case, the output voltage of the battery 200 is accessed to the voltage conversion circuit 110. The voltage conversion circuit 110 may convert the output voltage of the battery 200 into the operating voltage of the management unit 300 and supply power to the management unit 300.

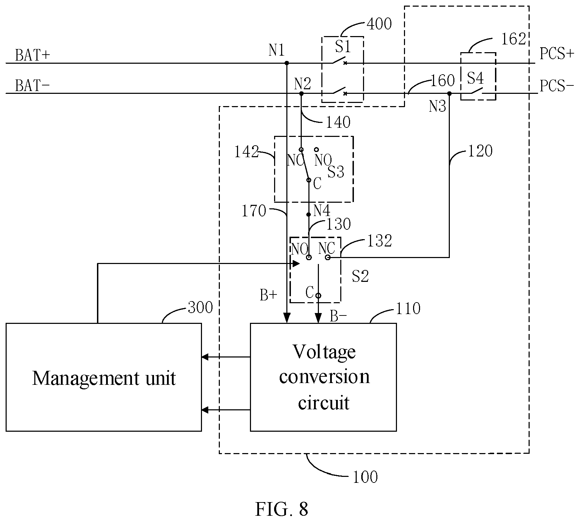

Further, referring to FIG. 8, when the first terminal is disconnected from the third terminal and the second terminal is disconnected from the third terminal, the B- terminal cannot be connected to the BAT- terminal by the first line 120 and the second line 130, and the BAT- terminal and the B- terminal are disconnected from each other. The voltage conversion circuit 110 is disconnected from the battery 200, causing the battery 200 to stop supplying power to the management unit 300.

Referring to FIG. 8, in some embodiments, the management unit 300 is configured to detect the operating state of the battery 200 and disconnect the third terminal from the first terminal and from the second terminal in response to the abnormal operating state of the battery 200 being detected.

In an exemplary embodiment of the present disclosure, the management unit 300 may control a connection state of the switch S3. When the abnormal operating state of the battery 200 is detected by the management unit 300, the battery 200 cuts off the charging and discharging path, and the battery 200 cuts off a connection with the external circuit 500. In this case, the first terminal is disconnected from the third terminal, and the second terminal is disconnected from the third terminal. The B- terminal cannot be connected to the BAT-terminal by the first line 120 and the second line 130, and thus the BAT- terminal and the B-terminal are disconnected from each other. The voltage conversion circuit 110 is disconnected from the battery 200, causing the battery 200 to stop supplying power to the management unit 300.

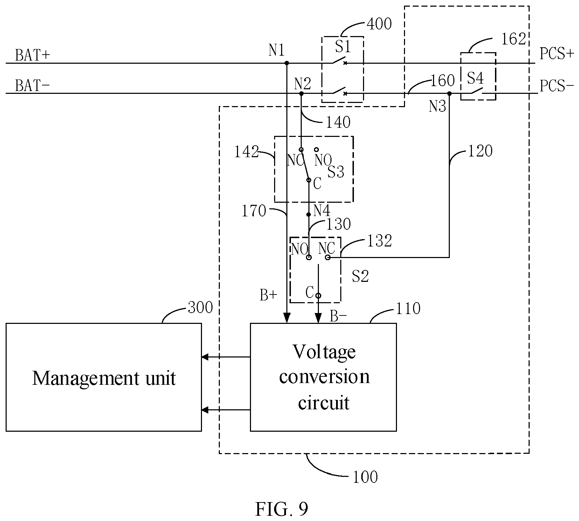

Referring to FIG. 9, in some embodiments, the first switch 132 is a single-pole double-throw switch.

In an exemplary embodiment of the present disclosure, the switch S2 may be a manual single-pole double-throw switch. The user may selectively connect the third terminal to the first terminal or to the second terminal, or selectively disconnect the third terminal from the first terminal or from the second terminal, as desired.

When the second terminal is connected to the third terminal, as described above, the voltage conversion circuit 110 may convert the output voltage of the battery 200 into the operating voltage of the management unit 300 and supply power to the management unit 300.

When the first terminal is disconnected from the third terminal and the second terminal is disconnected from the third terminal, as described above, the voltage conversion circuit 110 is disconnected from the battery 200, causing the battery 200 to stop supplying power to the management unit 300.

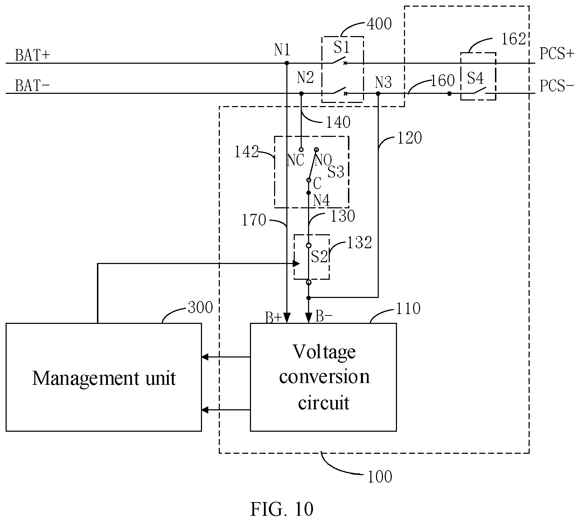

Referring to FIG. 10, in some embodiments, the power supply circuit 100 further includes a third line 140. The battery 200 is connected to the second line 130 by the third line 140. The third line 40 includes a second switch 142. The battery 200 is disconnected from the second line 130 when the second switch 142 is switched off.

When the second switch 142 is switched off, the battery 200 is disconnected from the second line 130, and the voltage conversion circuit 110 cannot supply power to the management unit 300 through the second line 130.

In an exemplary embodiment of the present disclosure, the third line 140 may be a connection line between the second node N2 and the fourth node N4, and the second switch 142 may include a switch S3.

When the switch S3 is switched off, the second node N2 and the fourth node N4 are disconnected from each other, and the BAT- terminal cannot be connected to the fourth node N4 through the second node N2. Further, the BAT- terminal cannot be connected to the B- terminal through the second node N2, the fourth node N4, and the switch S2, i.e., the BAT-terminal cannot be connected to the B- terminal by the third line 140 and the second line 130.

As described above, when the switch S1 is switched off, the BAT- terminal cannot be connected to the B- terminal by the first line 120. Therefore, when the switch S1 and the switch S3 are both switched off, the BAT- terminal cannot be connected to the B- terminal by the first line 120, and the BAT- terminal cannot be connected to the B- terminal by the second line 130, either. The voltage conversion circuit 110 is disconnected from the battery 200, causing the battery 200 to stop supplying power to the management unit 300.

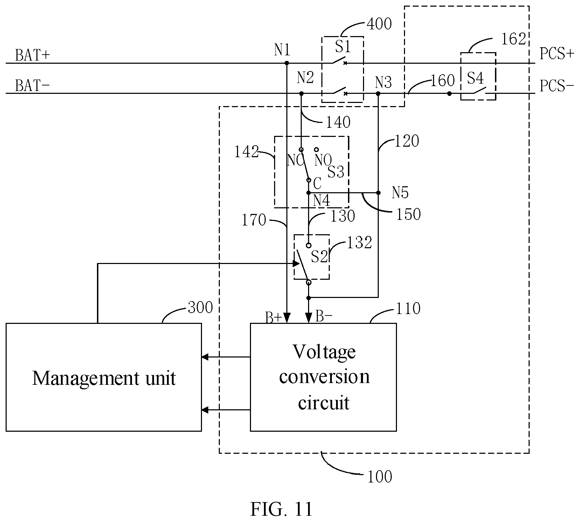

Referring to FIG. 11, in some embodiments, the power supply circuit further includes a fourth line 150. The fourth line 150 is connected to the first line 120 and the third line 140. When the second switch 142 is switched on, the battery 200 is connected to the voltage conversion circuit 110 by the third line 140, the fourth line 150, and the first line 120.

In an exemplary embodiment of the present disclosure, the fourth line 150 may be a connection line between the fourth node N4 and a fifth node N5. The fourth line 150 is connected to the first line 120 through the fifth node N5, and the fourth line 150 is connected to the third line 140 through the fourth node N4.

The fourth node N4 is connected to the fifth node N5, and the fifth node N5 is connected to the BAT- terminal. Further, the fourth node N4 is connected to the B- terminal. When the switch S3 is switched on, the BAT- terminal can be connected to the fourth node N4 through the second node N2, and the fourth node N4 is connected to the B- terminal. Thus, the BAT- terminal can be connected to the B- terminal through the fourth node N4. In this case, the battery 200 is connected to the voltage conversion circuit 110, and the voltage conversion circuit 110 can convert the output voltage of the battery 200 into the operating voltage of the management unit 300 and supply power to the management unit 300.

Referring to FIG. 10, in some embodiments, the second switch 142 includes a fourth terminal, a fifth terminal, and a sixth terminal. The fourth terminal is connected to the battery. The fifth terminal is suspended. The sixth terminal is connected to the second line. The second switch 142 is configured to selectively connect the sixth terminal to the fourth terminal or to the fifth terminal, or selectively disconnect the sixth terminal from the fourth terminal or from the fifth terminal.

In an exemplary embodiment of the present disclosure, the second switch 142 may include a switch S3. A fourth terminal of the switch S3 is connected to the second node N2, a fifth terminal of the switch S3 is suspended, and a sixth terminal of the switch S3 is connected to the fourth node N4.

When the fourth terminal is disconnected from the sixth terminal, the second node N2 and the fourth node N4 are disconnected from each other, and the BAT- terminal cannot be connected to the fourth node N4 through the second node N2. Further, the BAT- terminal cannot be connected to the B- terminal through the second node N2, the fourth node N4, and the switch S2, i.e., the BAT- terminal cannot be connected to the B- terminal by the third line 140 and the second line 130. The voltage conversion circuit 110 is disconnected from the battery 200, causing the battery 200 to stop supplying power to the management unit 300.

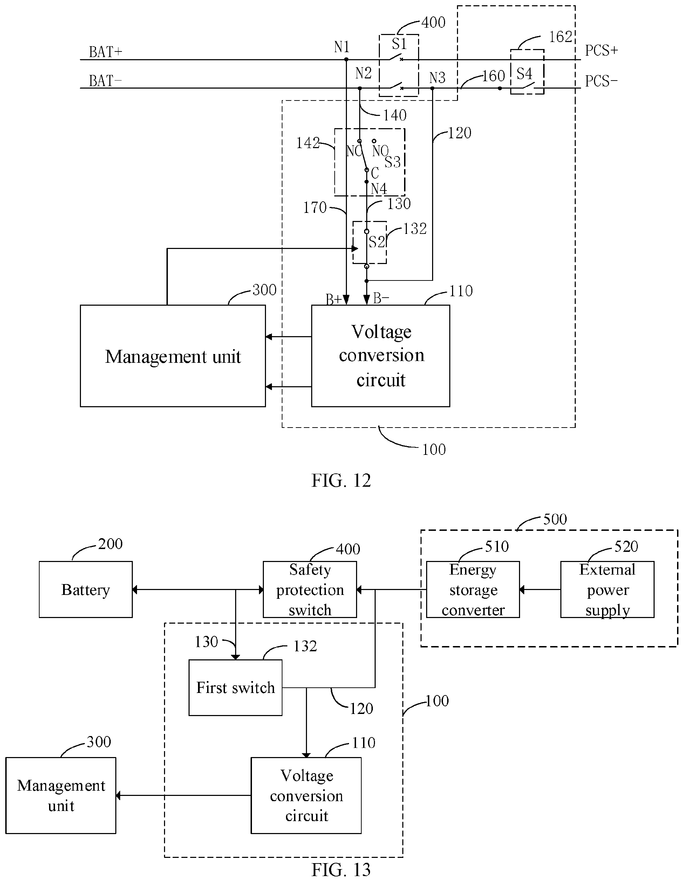

Further, referring to FIG. 12, in a case where the fourth terminal is connected to the sixth terminal, the second node N2 may be connected to the fourth node N4 by the second line 142. If the switch S2 is switched on, the fourth node N4 may be connected to the B-terminal, and the BAT- terminal may be connected to the B- terminal through the second node N2 and the fourth node N4. In this case, the battery 200 is connected to the voltage conversion circuit 110, and the voltage conversion circuit 110 can convert the output voltage of the battery 200 into the operating voltage of the management unit 300 and supply power to the management unit 300.

Referring to FIG. 12, in some embodiments, the second switch 142 is a single pole double throw switch.

In an exemplary embodiment of the present disclosure, the second switch 142 may be a manual single-pole double-throw switch. The user may selectively connect the sixth terminal to the fourth terminal or to the fifth terminal, or selectively disconnect the sixth terminal from the fourth terminal or from the fifth terminal, as desired.

When the fourth terminal is connected to the sixth terminal, and the switch S2 is switched on, as described above, the voltage conversion circuit 110 may convert the output voltage of the battery 200 into the operating voltage of the management unit 300 and supply power to the management unit 300.

When the fourth terminal is disconnected from the sixth terminal, and the switch S1 is switched off, as described above, the voltage conversion circuit 110 is disconnected from the battery 200, causing the battery 200 to stop supplying power to the management unit 300.

Referring to FIG. 13, in some embodiments, the external circuit 500 includes an energy storage converter 510 and an external power supply 520. When the safety protection switch 400 is switched on, the external power supply 520 can charge the battery through the energy storage converter 510. The voltage conversion circuit 110 is configured to convert, when the safety protection switch 400 is switched on, an output voltage of the energy storage converter 510 into the operating voltage of the management unit 300 through the first line 120 and supply power to the management unit 300.

In an exemplary embodiment of the present disclosure, when the battery 200 has insufficient power, a voltage of the external power supply 520 may be accessed to the energy storage converter 510 to supply power to the battery 200. The battery may also supply power to a load connected to the external circuit 500 through the energy storage converter 510.

The voltage of the external power supply 520 may be accessed to the energy storage converter 510 to supply power to the management unit 300. When the battery 200 has insufficient power, the external power supply 520 may supply power to the battery 200.

When the external power supply 520 charges the battery 200 through the energy storage converter 510, the management unit 300 of the battery 200 needs to monitor a charging of the battery 200. Due to the insufficient power of the battery 200, the battery 200 cannot output a voltage to supply power to the management unit 300 of the battery 200. In this case, the voltage of the external power supply 520 may be accessed to the energy storage converter 510 to supply power to the management unit 300 of the battery 200, to allow the management unit 300 to monitor a charging operation of the battery 200.

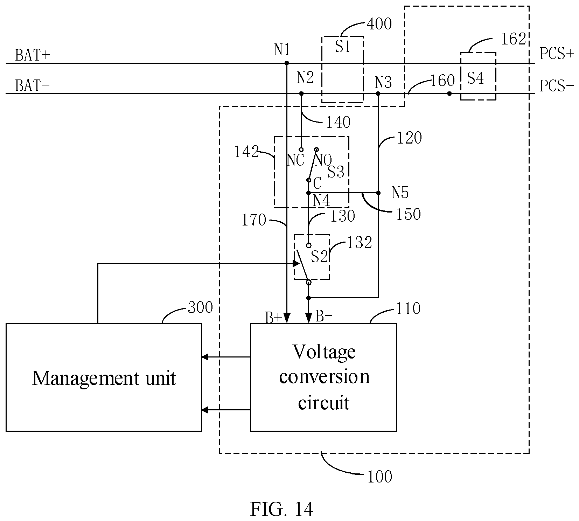

Referring to FIG. 14, in some embodiments, the power supply circuit 100 further includes a fifth line 160. The fifth line 160 is connected between the energy storage converter and the first line 120. The fifth line 160 includes a third switch 152. The third switch 152 is configured to be switched on when the safety protection switch 400 is switched on.

In an exemplary embodiment of the present disclosure, the third switch 152 may be a switch S4, and a line from the switch S1 to the PCS- is the fifth line 160. PCS+ may be configured to be connected to a positive pole of the energy storage converter 510, and the PCS may be configured to be connected to a negative pole of the energy storage converter 510.

BAT+ is connected to PCS+ by the switch S1, and BAT- is connected to PCS- by the switch S1 and switch S4. When the switch S1 is switched on, the switch S4 is also switched on, to connect the BAT+ to the PCS+ and connect the BAT- to the PCS-. At this time, the energy storage converter 510 is connected to the battery 200. Therefore, the external circuit 500 can supply power to the battery 200 through the energy storage converter 510, or the battery 200 can supply power to the external circuit 500 through the energy storage converter 510.

Referring to FIG. 14, in some embodiments, the power supply circuit 100 further includes a sixth line 170. The positive pole of the battery 200 is connected to the voltage conversion circuit 110 by the sixth line 170, and the negative pole of the battery 200 is connected to the voltage conversion circuit 110 by the second line 130 and the third line 140. The negative pole of the battery 200 is also connected to the voltage conversion circuit 110 by the first line 120.

In an exemplary embodiment of the present disclosure, a connection line between the first node N1 and the B+ terminal may be a sixth connection line. The B+ terminal may be directly connected to the BAT+ by the sixth line 170.

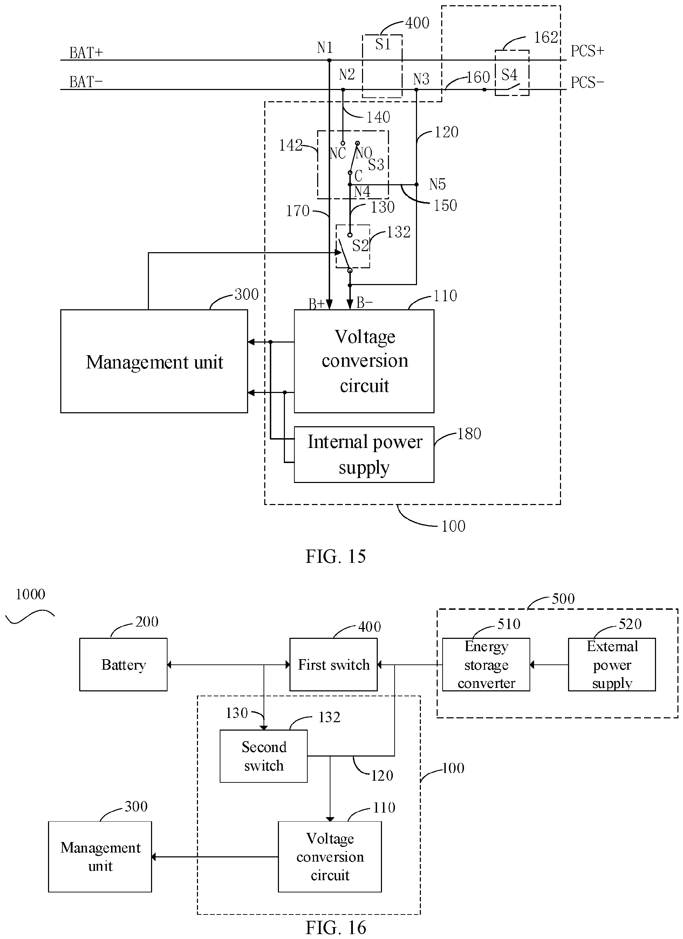

Referring to FIG. 15, in some embodiments, the power supply circuit 100 includes an internal power supply 180. The internal power supply 180 is connected to the management unit 300 to supply power to the management unit 300.

In an exemplary embodiment of the present disclosure, the management unit 300 of the battery 200 has a corresponding internal power supply 180. When the battery 200 has insufficient power, the internal power supply 180 may supply power to the management unit 300. In a case where the charging device charges the battery 200, when the battery 200 has insufficient power in such a manner that the battery 200 cannot supply power to the management unit 300, the internal power supply 180 may supply power to the management unit 300. The internal power supply 180 supplies power to the management unit 300 to allow the management unit 300 to operate normally and monitor the operating state of the battery 200 during the charging.

An embodiment of the present disclosure provides a battery monitoring circuit. The battery monitoring circuit includes the power supply circuit 100 according to any one of the above embodiments and the management unit 300.

In an exemplary embodiment of the present disclosure, during the operation of the battery 200, the power supply circuit 100 keeps supplying power to the management unit 300 to allow the management unit to always monitor the operating state of the battery 200. Therefore, a protection can be activated by the power supply circuit 100 in time when a fault or even potential safety hazards occur in the battery 200. As a result, safety of the battery 200 can be improved.

For embodiments of the power supply circuit 100 and the management unit 300, reference may be made to the above embodiments, and beneficial effects of the battery monitoring circuit include all beneficial effects of the power supply circuit 100 and the management unit 300, and details thereof are omitted herein.

Referring to FIG. 16, an embodiment of the present disclosure provides an energy storage device 1000. The energy storage device 1000 includes the battery monitoring circuit according to any one of the above embodiments and a battery 200.

For embodiments of the battery monitoring circuit and the battery 200, reference may be made to the foregoing embodiments, and beneficial effects of the energy storage device 1000 include all beneficial effects of the battery monitoring circuit, and details thereof will be omitted herein.

In the power supply circuit 100, the battery monitoring circuit, and the energy storage device 1000 according to the embodiments of the present disclosure, the power supply circuit 100 is configured to control the battery 200 to supply power to the management unit 300 of the battery 200. In one power supply loop, the voltage of the battery 200 is accessed to to the voltage conversion circuit 110 through the safety protection switch 400 and the first line 120, and then the voltage conversion circuit 110 converts the voltage of the battery 200 into the operating voltage of the management unit 300 to supply power to the management unit 300. In another power supply loop, the voltage of the battery 200 is accessed to the voltage conversion circuit 110 through the second line 130, and then the voltage conversion circuit 110 converts the voltage of the battery 200 into the operating voltage of the management unit 300 to supply power to the management unit 300. When the safety protection switch 400 is switched off, the battery 200 cannot be connected to the voltage conversion circuit 110 by the first line 120. In this case, when the first switch 132 is switched on, the battery 200 can be connected to the voltage conversion circuit 110 by the second line 130. As a result, the voltage of the battery 200 can be accessed to the voltage conversion circuit 110 through the second line 130, and then the voltage conversion circuit 110 converts the voltage of the battery 200 into the operating voltage of the management unit 300 to supply power to the management unit 300, so that the management unit 300 can operate normally. In this way, damage to the battery 200 or occurrence of safety issue in the battery 200 generated because the management unit 300 cannot monitor the battery 200 can be avoided when a fault or even potential safety hazards occur in the battery 200.

In the description of this specification, descriptions with reference to the terms "an embodiment," "some embodiments," "illustrative embodiments," "examples," "specific examples," or "some examples" etc., mean that specific features, structure, materials or characteristics described in conjunction with the embodiment or example are included in at least one embodiment or example of the present disclosure. In this specification, the schematic representations of the above terms do not necessarily refer to the same embodiment or example. In addition, those skilled in the art can combine the different embodiments or examples and the features of the different embodiments or examples described in this specification without contradicting each other.

In addition, technical terms such as "connect to" should be understood in a broad sense. For example, it may be a fixed connection or a detachable connection or connection as one piece; a direct connection or an indirect connection through an intermediate; internal communication of two components. For those skilled in the art, the specific meaning of the above-mentioned terms in the present disclosure can be understood according to specific circumstances.

In addition, the term "first" or "second" is only for descriptive purposes, rather than indicating or implying relative importance or implicitly indicating the number of indicated technical features. Therefore, the features associated with "first" or "second" can explicitly or implicitly include at least one of the features. In the description of the present disclosure, "plurality of" means at least two, unless otherwise specifically indicated.

Any process or method described in a flowchart or described herein in other ways can be understood to include one or more modules, segments, or portions of codes of executable instructions for achieving specific logical functions or steps in the process. The scope of a preferred embodiment of the present disclosure includes other embodiments. A function may be performed not in a sequence shown or discussed, including a substantially simultaneous manner or a reverse sequence based on the function involved, which should be understood by those skilled in the art to which the embodiments of the present disclosure belong.

Although embodiments according to the present disclosure have been shown and described, it would be appreciated by those skilled in the art that the above embodiments are illustrative and cannot be construed to limitation on the present disclosure, and changes, alternatives, modifications, and variations can be made in the embodiments without departing from scope of the present disclosure.

## Claims

1. A power supply circuit (100) for supplying power to a management unit (300) of a battery (200), wherein the battery (200) is connected to an external circuit (500) by a safety protection switch (400), the power supply circuit (100) comprising:
a first line (120);
a second line (130); and
a voltage conversion circuit (110) connected to two terminals of the safety protection switch (400) by the first line (120) and the second line (130) respectively, the voltage conversion circuit (110) being configured to convert an output voltage of the battery (200) into an operating voltage of the management unit (300) and supply power to the management unit (300),
wherein the second line (130) comprises a first switch (132), the first switch (132) being configured to be switched on when the safety protection switch (400) is switched off, to cause the battery (200) to supply power to the management unit (300) by the voltage conversion circuit (110) via the second line (130).

2. The power supply circuit (100) according to claim 1, wherein the first switch (132) is a manual switch that is manually switchable off by a user.

3. The power supply circuit (100) according to claim 1, wherein:
the first switch (132) has a first terminal connected to the battery (200), a second terminal connected to the first line (120), and a third terminal connected to the voltage conversion circuit (110); and
the first switch (132) is configured to selectively connect the third terminal to the first terminal or to the second terminal, or selectively disconnect the third terminal from the first terminal or from the second terminal.

4. The power supply circuit (100) according to claim 3, wherein the first switch (132) is a single-pole double-throw switch.

5. The power supply circuit (100) according to claim 1, further comprising a third line (140), the battery (200) being connected to the second line (130) by the third line (140),
wherein the third line (140) comprises a second switch (142), the battery (200) being disconnected from the second line (130) when the second switch (142) is switched off.

6. The power supply circuit (100) according to claim 5, further comprising a fourth line (150) connected to the first line (120) and the third line (140), the battery (200) being connected to the voltage conversion circuit (110) by the third line (140), the fourth line (150), and the first line (120) when the second switch (142) is switched on.

7. The power supply circuit (100) according to claim 5, wherein:
the second switch (142) has a fourth terminal connected to the battery (200), a fifth terminal that is suspended, and a sixth terminal connected to the second line (130); and
the second switch (142) is configured to selectively connect the sixth terminal to the fourth terminal or to the fifth terminal, or selectively disconnect the sixth terminal from the fourth terminal or from the fifth terminal.

8. The power supply circuit (100) according to claim 7, wherein the second switch (142) is a single-pole double-throw switch.

9. The power supply circuit (100) according to claim 1, wherein:
the voltage conversion circuit (110) is configured to convert, when the safety protection switch (400) is switched on, an output voltage of an energy storage converter (510) of the external circuit (500) into the operating voltage of the management unit (300) through the first line (120) and supply power to the management unit (300).

10. The power supply circuit (100) according to claim 1, further comprising a fifth line (160) connected between an energy storage converter (510) and the first line (120), the fifth line (160) comprising a third switch (152) configured to be switched on when the first switch (132) is switched on.

11. The power supply circuit (100) according to claim 1, further comprising an internal power supply (180) connected to the management unit (300) to supply power to the management unit (300).

12. A battery monitoring circuit, comprising:
the power supply circuit (100) according to any one of claims 1 to 11; and
the management unit (300).

13. The battery monitoring circuit according to claim 12, wherein the management unit (300) is configured to control the first switch (132) to be switched off in response to an abnormal operating state of the battery (200) being detected.

14. The battery monitoring circuit according to claim 12 or 13, wherein:
the first switch (132) has a first terminal connected to the battery (200), a second terminal connected to the first line (120), and a third terminal connected to the voltage conversion circuit (110);
the first switch (132) is configured to selectively connect the third terminal to the first terminal or to the second terminal, or selectively disconnect the third terminal from the first terminal or from the second terminal; and
the management unit (300) is configured to disconnect the third terminal from the first terminal and from the second terminal in response to an abnormal operating state of the battery (200) being detected.

15. An energy storage device, comprising:
a battery (200); and
the battery monitoring circuit according to any one of claims 12 to 14.
